# EUROPEAN PATENT APPLICATION

(11) **EP 0 690 515 A1**
(43) Date of publication of application: **03.01.1996**
(21) Application number: 95107467.3
(22) Date of filing: 17.05.1995
(51) Int. Cl.: H01L 31/0203

(54) **Optoelectronic assembly and methods for producing and using the same**

(30) Priority: 30.06.1994 US 268483
(71) Applicant: EASTMAN KODAK COMPANY, Rochester, New York 14650 (US)
(72) Inventor: Wetzel, Keith E., Eastman Kodak Company, Rochester, New York 14650-2201 (US)
(74) Representative: Blickle, K. Werner, Dipl.-Ing.

(57) **Abstract**

An optoelectronic assembly (10) which can be utilized as a photo-transmitter and/or a photo-receiver. The assembly (10) generally includes a circuit substrate (12) having a transparent portion which is substantially transparent to a desired portion of the radiation spectrum, such as can be provided by flexible polyester material. A photoelectric device (18), having a photoactive portion on a front surface thereof, is positioned with its front surface facing toward with the transparent portion of the circuit substrate (12). An electrical component (14) is positioned on the circuit substrate (12) and is operatively connected with the photoelectric device (18) via an electrical conductor (16). The photoelectric device further includes a bond pad (22) positioned on the front surface thereof, and adhesive which bonds the bond pad (22) to the electrical conductor (16).

## Description

### FIELD OF THE INVENTION

The invention relates generally to optoelectronic assemblies, such as photo-transmitters and photoreceivers, and methods for making and using the same.

### BACKGROUND OF THE INVENTION

Optoelectronic assemblies typically comprise a optical system, such as a lens, located in front of a photoelectronic device. For example, the photoelectric device can be a radiation-emitting or radiation-detecting device. The photoelectric device has an optically active portion thereon and further has contact areas for electrical connection.

Optoelectronic assemblies as generally described above can be used for a variety of purposes, such as camera autofocus applications or exposure control applications. In such devices, the contact areas of the photoelectric device are electrically connected to a circuit board. The circuit board further has electrical components.

One disadvantage of known optoelectronic assemblies is the expense of manufacture. In known assemblies, photoelectric devices are packaged as leaded, surface mount or throughhole components. The photoelectric device is positioned on a metal leadframe, interconnected to the leadframe with wire bonding technology, and molded with a transparent plastic encapsulating material. This component is then interconnected to a next higher assembly which can consist of a rigid circuit substrate using hand soldering or wave soldering methods. These components are complex to manufacture and custom packaging requires additional expenditures for custom tooling for leadframes and molds. These components are relatively large compared to the actual photoelectric device and alignment of the photoelectric device to optical elements is difficult because the location of the photoelectric device with respect to the leadframe is not sufficiently precise.

In other known assemblies, wherein the photoelectric device is positioned to have its optically sensitive area facing the circuit board, an aperture is required to be cut in the circuit board to provide an unobstructed path for the radiation sensitive or radiation emitting region to receive or emit radiation. Further, electrical connection between the photoelectric device and the circuit board is required, which requires additional manufacturing steps. Further, special tooling is usually required to cut the aperture, position the photoelectric device in the circuit board, electrically interconnect the circuit board and photoelectric device, and generally to manufacture the optoelectronic assembly. All of these factors increase the complexity and the cost of manufacturing.

US-A-5,149,958 by Hallenbach et al, assigned to Eastman Kodak Company, issued June 8, 1993, discloses an optoelectronic assembly comprising an optical element, photoelectric device and a printed circuit board which is electrically connected to the photoelectric device. The optoelectronic assembly is disclosed as having an aperture in the circuit board to receive the photoelectric device and allow the light sensitive area to receive light. The optoelectronic device further includes electrical conductors to be formed on a surface of the optical element, for example, by vacuum deposition or thick film screening techniques for electrical interconnection

In Hallenbach et al, the optical element is located in front of the photoelectric device by first attaching the photoelectric device to the optical element by the use of clear non-conductive adhesive, the optical element previously having conductive material masked upon it and having a first bump for connection with the die bond pad of the photoelectric device and a second bump for connection with the conductor of the circuit board. The photoelectric portion of the combination photoelectric/optical element is then aligned with an aperture previously cut in the circuit board for insertion of the photoelectric device.

Japanese Laid-Open Patent Publication No. 59-198770 discloses a photo-receiving electronic device. The device is a photo-receiving element which is mounted with its optically sensitive area facing a transparent glass substrate. The photo-receiving element is spaced from the glass substrate due to the interconnection of bump electrodes of the photo-receiving element and conductive parts of the glass substrate.

It would be desirable to eliminate leadframes and clear molding compounds, and minimize optical alignment issues that can later be complicated by leadframe packages. It would also be desirable to eliminate manufacturing steps in connection with the production of optoelectronic assemblies, such as cutting an aperture in a circuit board. It would also be desirable to minimize limitations placed on the optoelectronic assembly which result from using rigid circuit boards including, for example, size limitations in camera applications and problems associated with unequal thermal expansion of components.

### SUMMARY OF THE INVENTION

In accordance with one aspect of the present invention, an optoelectronic assembly is provided which includes a flexible circuit substrate including a portion which is substantially transparent to a desired portion of the radiation spectrum, and a photoelectric device (e.g., a photo-emitter, a photo-receiver, a photo-reflector, a photo-transmitter, etc.) having a photoactive portion on a front surface thereof. The front surface of the photoelectric device is positioned to face toward the transparent portion of the circuit substrate. If desired, the flexible transparent circuit substrate may be positioned adjacent to and secured to a rigid and/or opaque circuit board. Preferably, the flexible circuit substrate comprises polyester, polyamide, PEN or PET.

In one embodiment, the assembly further comprises at least one electrical component positioned on the circuit substrate, and an electrical conductor positioned on the circuit substrate to provide operative connection between the photoelectric device and the electrical component. Preferably, the electrical component and the electrical conductor are positioned on the transparent portion of the circuit substrate. The photoelectric device may further comprise at least one bond pad for providing operative connection between the photoelectric device and the electrical conductor. Preferably, the bond pad is positioned on the front surface of the photoelectric device. In one embodiment, a conductive adhesive (e.g., an anisotropic, isotropic, or monosotropic adhesive) is utilized to bond the photoelectric device to the circuit substrate. In another embodiment, the bond pad includes a conductive bump for facilitating connection to the electrical conductor on the circuit substrate. The assembly can further include an optical element (e.g., a lens) positioned adjacent the transparent portion of the substrate in opposing relation to the photoactive portion of the photoelectric device.

In another aspect of the present invention, a method for producing an optoelectronic assembly is provided. The method generally comprises the steps of providing a circuit substrate having a portion which is substantially transparent to a desired portion of the radiation spectrum and an electrical conductor positioned thereon, providing a photoelectric device having a photoactive portion on a front surface thereof, positioning the photoactive portion of the photoelectric device to face the transparent portion of the circuit substrate, securing the photoelectric device to the circuit substrate such that the front surface thereof faces toward the circuit substrate to provide operative connection between the photoelectric device and the electrical conductor, and securing an electrical component to the circuit substrate such that the electrical component is operatively connected to the electrical conductor. In one embodiment, the photoelectric device includes a bond pad on the front surface thereof, and the method further comprises the step of aligning the bond pad of the photoelectric device with the electrical conductor and operatively connecting the two. In another embodiment, the bond pad includes conductive bumps.

The step of securing preferably comprises applying a conductive adhesive (e.g., an anisotropic, isotropic or monosotropic adhesive) to at least one of the circuit substrate and the photoelectric device, and positioning the front surface of the photoelectric device to face toward the circuit substrate. When the conductive adhesive is applied to the circuit substrate, it should at least partially cover the electrical conductor. When the conductive adhesive is applied to the photoelectric device, it should at least partially cover the bond pad. In one embodiment, the method further comprises the step of positioning an optical element (e.g., a lens) adjacent the substrate in opposing relation to the photoactive portion of the photoelectric device. In another embodiment, the circuit substrate comprises a flexible material.

In yet another aspect of the present invention, a method is provided for using an optoelectronic assembly having a flexible circuit substrate and a photoelectric device (e.g., a photo-emitter, a photo-receiver, a photo-reflector, a photo-transmitter, etc.) positioned thereon. The method generally comprises the steps of passing radiation through at least a portion of the circuit substrate and altering an electrical characteristic of the photoelectric device. In one embodiment, the method further comprises the step of exchanging a signal between the photoelectric device and an electrical component positioned on the circuit substrate.

In an embodiment of the present invention, an optoelectronic assembly, and corresponding methods for making and using the same, is provided which enhances flexibility while maintaining efficiency and reliability and which can be manufactured in an efficient and straight forward manner. In an embodiment of the present invention, an optoelectric assembly is provided wherein the alignment of the photoelectric device relative to optical elements is simplified. In one embodiment of the present invention, an optoelectronic assembly is provided which minimizes tooling costs. In an embodiment of the present invention, an optoelectronic assembly is provided which improves high frequency performance and minimizes emissions of electromagnetic radiation by locating active electrical components in close proximity to the photoelectric device. In an embodiment of the present invention, an optoelectronic assembly is provided which is small, light in weight and easily integrated into higher level assemblies.

### BRIEF DESCRIPTION OF THE DRAWINGS

- Fig. 1: is a bottom view, looking through the transparent circuit board, of an embodiment of an optoelectronic assembly according to the present invention.
- Fig. 2: is a sectional view taken along line 2-2 of Fig. 1.
- Fig. 3: is a sectional view of an alternative embodiment of the device of the present invention.

### DETAILED DESCRIPTION

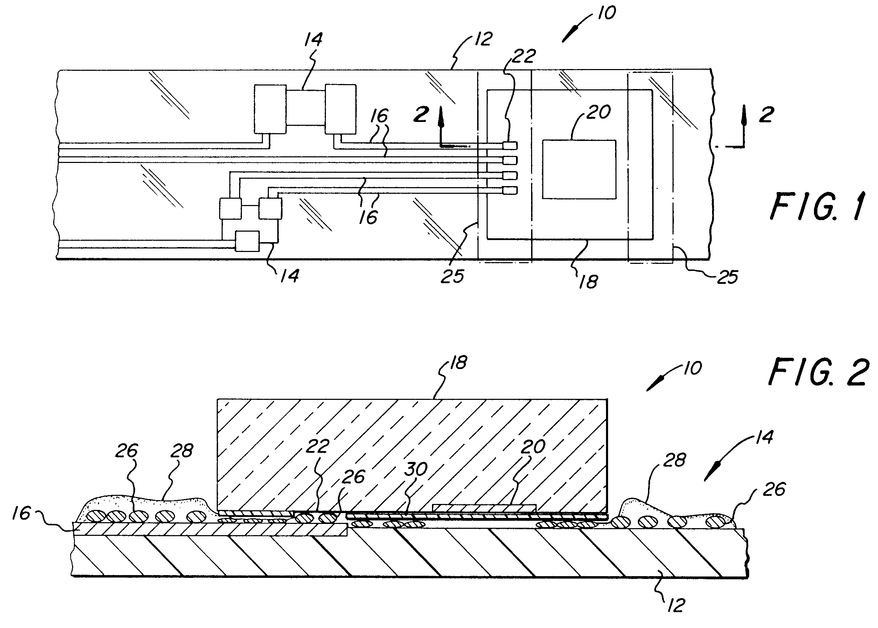

An optoelectronic assembly 10 embodying features of the present invention is illustrated in Figs. 1 and 2. The illustrated assembly 10 generally comprises a circuit substrate 12, surface mount technology components 14, a photoelectric device 18, and electrical conductors 16. The circuit substrate 12 of the present invention is specifically designed to include a transparent portion which is substantially transparent to a desired portion of the radiation spectrum. For example, in one embodiment, the described optoelectronic assembly 10 is utilized to detect the intensity of visible light impinging thereon and, therefore, the circuit substrate 12 of such embodiment is substantially transparent to visible light. The circuit substrate 12 may comprise any appropriate material, preferably a flexible polymeric material, and more preferably a polyester material such as polyethylene terephthalate ("PET"), an example of which is Mylar, a trademark of E.I. Du Pont de Nemours & Co. Other materials that may be utilized include polyethylene naphthalate ("PEN"), available from Amoco, polyimide and acetate. As used herein, the term "flexible" means any substrate in which the shape can be changed by hand, without tools, while still maintaining electrical and mechanical integrity. For example, the substrate preferably can bend at least 10°, more preferably at least 20°, more preferably at least 45°, and more preferably at least 90°, without mechanical or electrical failure.

The components 14 of the illustrated embodiment are mounted directly on the circuit substrate 12 and may comprise any of a variety of different components. For example, components such as resistors, capacitors, transistors and integrated circuits could be utilized, depending on the particular optoelectronic assembly being designed.

The photoelectric device 18 of the present invention is mounted on the circuit substrate 12 and may comprise any of a number of different photoelectric devices. For example, if it is desired to have the assembly emit radiation, the photoelectric device 18 may comprise a photo-emitter, such as light emitting diodes or diode arrays available from Hewlett Packard, Quality Technology, and Siemans. On the other hand, if it is desired for the assembly to receive and detect radiation, the photoelectric device 18 may comprise a photo-receiver. The photoelectric device 18 may also include devices in which radiation is reflected/absorbed ("photo-reflector") or transmitted/absorbed ("photo-transmitter"). For example, the photoelectric device may include light emitting diodes, light valves, charge coupled devices, slotted switches or slotted interruptors. In the illustrated embodiment, the photoelectric device 18 is a photodiode which acts as a photometer to measure ambient radiation intensity.

The photoelectric device 18 comprises a photoactive region 20 which, when exposed to radiation, alters the electrical characteristics of the photoelectric device 18. For example, in the illustrated embodiment, the photoelectric device 18 is a semiconductor and the photoactive region 20 is doped to alter the electrical conductivity of the semiconductor in response to changing radiation conditions, as is known in the art. The photoelectric device 18 further includes bond pads 22 for providing a location for attachment of electrical conductorsá16 to the photoelectric device 18. The bond pads 22 are typically metallized with aluminum, but may be plated, for example with a thin layer of gold. The bond pads 22 may also have conductive bumps (not shown) positioned thereon for electrically connecting to the electrical conductors 16. These bumps can be made of a variety of materials, such as gold or tin/lead. The bumps eliminate the need for a conductive adhesive. In the illustrated embodiment, the photoactive region 20 and the bond pads 22 are located on the same side of the photoelectric device 18 (i.e., facing toward the circuit substrate 12).

The photoelectric device 18 is further provided with a passivation layer 30 (Fig. 2) on the same side as that occupied by the bond pads 22 and the photoactive region 20. The passivation layer 30 electrically insulates the photoelectric device 18 (except for the bond pads 22) from the circuit substrate 12 and associated electrical conductors 16. The passivation layer 30 further acts to passivate the photoactive region 20. In the illustrated embodiment, such passivation layer 30 comprises a 1-2 micron thick layer of silicon nitride or silicon dioxide, which is deposited by thin film deposition techniques as part of the photoelectric device manufacturing process. It should be appreciated that other passivation materials and thicknesses could also be used.

The photoelectric device 18 is secured to the circuit substrate 12 such that the bond pads 22 are electrically interconnected with the electrical conductors 16. Such securement can be accomplished utilizing an appropriate adhesive 24. For example, isotropic adhesives can be utilized, especially when the photoelectric device bond pads are bumped. Monosotropic adhesives can also be utilized. These materials are similar to anisotropic adhesive except the conductive particles are screen printed on top of the conductors. The entire structure of conductors with particles is coated with adhesive. In the illustrated embodiment, the photoelectric device 18 is bonded to the circuit substrate 12 utilizing an anisotropic conductive adhesive 24 (Fig. 2). Anisotropic conductive adhesives typically comprise a plurality of conductive particles 26 suspended in an adhesive matrix 28. For example, the adhesive sold under the product number 5303R by the 3M Corporation, or modifications thereof, could be utilized.

During assembly, the adhesive 24 is applied to the top surface of the circuit substrate 12, as generally illustrated by the rectangular regions 25 in Fig. 1. The photoelectric device 18 is subsequently positioned on the circuit substrate 12 with the photoactive region 20 and bond pads 22 facing toward the circuit substrate 12. The photoelectric device 18 is maintained in position until the adhesive 24 has cured. In the illustrated embodiment, no adhesive 24 is applied to the area of the circuit substrate 12 through which radiation will pass going to or coming from the photoactive region 20. In another embodiment, the adhesive 24 is applied over the entire bonding surface of the circuit substrate 12 including the area of the circuit substrate through which radiation will pass.

Conductive adhesive interconnection is preferred. Alternatively, there are other methods that can be employed. For example, thermocompression gold to gold bonding using bumped photoelectric device bond pads can be used. Additionally, soldering techniques wherein eutectic solder is applied to the flexible circuit conductors and the solder is reflowed to interconnect the circuit conductors to bumps on the photoelectric bond pads can be used. If used, the bumps on the photoelectric bond pads should have a higher melting temperature than the eutectic solder and should typically comprise 90-95% tin and 5-10% lead. Further, the flexible circuit substrate material should have a melting point which will withstand solder reflow temperatures.

The electrical conductors 16 provide electrical interconnection between the bond pads 22 of the photoelectric device 18 and other components (e.g., surface mount technology components 14). The electrical conductors 16 can be any appropriate conductor and can be formed onto the circuit substrate 12 by appropriate techniques, such as vacuum deposition, thin film deposition, foil laminates and screening techniques. In the illustrated embodiment, the electrical conductors 16 comprise gold-coated copper and are applied to the circuit substrate 12 via thin film deposition and plating techniques. In another embodiment, the electrical conductors 16 comprise polymer thick film ink, such as a silver-loaded or carbon-loaded adhesive, deposited via screening techniques.

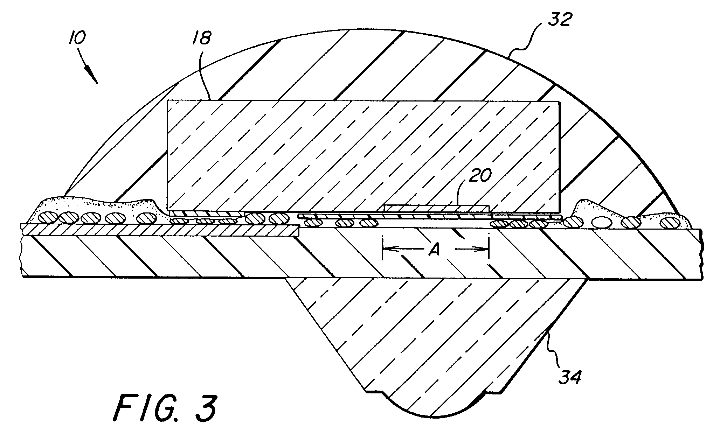

The optoelectronic assembly 10 of the present invention may further optionally include a protective encapsulant 32 on a back surface thereof, as illustrated in Fig. 3. The protective encapsulant 32 protects the back surface of the photoelectric device 18 from damage and/or degradation. Preferably, the protective encapsulant 32 is a non-conductive, opaque material which can be applied to the assembly in liquid form and subsequently cured by, for example, thermal, radiation or catalytic curing. In the illustrated embodiment, the protective encapsulant 32 could comprise material which is commercially available from Ablestik and identified as product 933-1.5. As an alternative, the protective encapsulant 32 could also comprise a solid cap attached to the circuit substrate 12.

As further shown in Fig. 3, the optoelectronic assembly 10 may comprise an optical element 34 secured (e.g., adhesively) to the circuit substrate 12 for focusing radiation onto the photoactive region 20. Utilizing such an optical elementá34, light entering the front surface of the optical element 34 will converge onto the photoactive region 20. For example, a desired field of view (or field coverage) may correspond to the area designated by A. When utilized as a light emitter, light emanating from area A is collimated by optical element 34 as it exits the front surface of the optical element 34.

It should be appreciated that the assembly 10 of the present invention could be utilized to perform radiation emission, radiation detection, radiation reflection, or radiation transmission functions. In addition, the assembly 10 could be utilized in any of a number of different applications. For example, in the illustrated embodiment, the assembly 10 is a photometer which is specifically designed for use as a light level indicator for varying the working parameters of light-sensitive devices, such as cameras. In addition, the concepts of the present invention could be applied to displays using, for example, light emitting diodes or light valves, imaging applications using, for example, charge coupled devices or photodiode arrays, control applications using, for example, optocouplers, slotted switches or slotted interruptors, optical storage applications using, for example, lasers, and printers using, for example, lasers or light emitting diodes.

The foregoing description of the present invention has been presented for purposes of illustration and description. Furthermore, the description is not intended to limit the invention to the form disclosed herein. Consequently, variations and modifications commensurate with the above teachings, and the skill or knowledge of the relevant art, are within the scope of the present invention. The embodiments described herein are further intended to explain best modes known for practicing the invention and to enable others skilled in the art to utilize the invention in such, or other, embodiments and with various modifications required by the particular applications or uses of the present invention. It is intended that the appended claims be construed to include alternative embodiments to the extent permitted by the prior art.
The invention is summarized as follows:
1. An optoelectronic assembly 10 comprising:
   (a) a flexible circuit substrate 12 including at least a portion which is substantially transparent to a desired portion of the radiation spectrum; and
   (b) a photoelectric device 18 having a photoactive portion on a front surface, said front surface facing said transparent portion of said circuit substrate 12.
2. The optoelectronic assembly 10 as set forth in item 1, further comprising:
   (i) at least one electrical component positioned on said circuit substrate 12; and
   (ii) at least one electrical conductor 16 inter-connecting said electrical component with said photoelectric device 10.
3. The optoelectronic assembly 10 as set forth in item 2, wherein said photoelectric device 18 further comprises at least one bond pad 22 for providing operative connection between said photoelectric device 18 and said electrical conductor 16.
4. The optoelectronic assembly 10 as set forth in item 3, wherein said bond pad is positioned on said front surface of said photoelectric device 18.
5. The optoelectronic assembly 10 as set forth in item 1, wherein said photoelectric device 18 is bonded to said circuit substrate 12 utilizing an electrically conductive adhesive 24.
6. The optoelectronic assembly 10 as set forth in item 1, wherein said photoelectric device is bonded to said circuit substrate 12 utilizing an adhesive 24 selected from the group consisting of: anisotropic adhesive, isotropic adhesive, and monosotropic adhesive.
7. The optoelectronic assembly 10 as set forth in item 1, wherein said circuit substrate 12 comprises a flexible polymer.
8. The optoelectronic assembly 10 as set forth in item 7, wherein said circuit substrate 12 comprises a material selected from the group consisting of: polyester, polyamide, PEN and PET.
9. The optoelectronic assembly 10 as set forth in item 1, further comprising an optical element 34 positioned adjacent said transparent portion of said circuit substrate 12 in opposing relation to said photoactive portion of said photoelectric device 18.
10. The optoelectronic assembly 10 as set forth in item 1, wherein said photoelectric device 18 comprises a device selected from the group consisting of: a photo-emitter, a photo-receiver, a photo-reflector, and a photo-transmitter.
11. The optoelectronic assembly 10 as set forth in item 1, wherein all of said circuit substrate 12 is substantially transparent to the desired portion of the radiation spectrum.
12. A method for producing an optoelectronic assembly 10 , said method comprising the steps of:
   (a) providing a circuit substrate 12 having at least a portion which is substantially transparent to a desired portion of the radiation spectrum, and further including an electrical conductor 16 positioned thereon;
   (b) providing a photoelectric device 18 having a photoactive portion on a front surface thereof;
   (c) positioning the photoactive portion of the photoelectric device 18 to face the transparent portion of the circuit substrate 12;
   (d) securing the photoelectric device 18 to the circuit substrate such that the front surface of the photoelectric device 18 faces toward the circuit substrate 12 to provide operative connection between the photoelectric device 18 and the electrical conductor 16; and
   (e) securing an electrical component to the circuit substrate 12 to provide operative connection between the electrical component and the electrical conductor 12.
13. The method, as set forth in item 12, wherein said photoelectric device 18 includes a bond pad 22 on the front surface thereof, and wherein said method further comprises the step of aligning the bond pad 22 of the photoelectric device 18 with the electrical conductor 16.
14. The method, as set forth in item 13, wherein said bond pad 22 includes conductive bumps.
15. The method, as set forth in item 12, wherein said step of securing comprises:
   (i) applying a conductive adhesive 24 to at least one of:
      a) the circuit substrate 12, to at least partially cover the electrical conductor 16, and
      b) the photoelectric device 18, to at least partially cover the bond pad 22; and
   (ii) positioning the front surface of the photoelectric device 18 to face toward the circuit substrate 12.
16. The method, as set forth in item 15, wherein said conductive adhesive 24 is selected from the group consisting of an anisotropic adhesive, an isotropic adhesive, and a monosotropic adhesive.
17. The method, as set forth in item 12, further comprising the step of positioning an optical element 34 adjacent said circuit substrate 12 in opposing relation to said photoactive portion of said photoelectric device 18.
18. The method, as set forth in item 12, wherein the circuit substrate 12 comprises a flexible material.
19. A method for using an optoelectronic assembly 10 comprising a photoelectric device 18 positioned on a flexible circuit substrate 12, said method comprising the steps of:
   (a) passing radiation through at least a portion of the flexible circuit substrate 12; and
   (b) altering an electrical characteristic of the photoelectric device 18.
20. The method, as set forth in item 19, wherein said photoelectric device 18 is selected from the group consisting of: a photo-emitter, a photo-receiver, a photo-reflector, and a photo-transmitter.
21. The method, as set forth in item 19, further comprising the step of exchanging a signal between the photoelectric device 18 and an electric component 14 positioned on the circuit substrate 12.
22. An optoelectronic assembly 10 comprising:
   (a) a circuit substrate 12 including a flexible polymer material which is substantially transparent to a desired portion of the radiation spectrum;
   (b) at least one electrical component 14 positioned on said circuit substrate 12;
   (c) a photoelectric device 18 having a photoactive portion and a bond pad 22 on a front surface thereof, said front surface being positioned to face toward said circuit substrate 12;
   (d) an electrical conductor 22 positioned on said circuit substrate 12 and capable of providing operative connection between said bond pad 22 of said photoelectric device 18 and said electrical component 14; and
   (e) conductive adhesive 24 positioned between said bond pad 22 and said electrical conductor 16.

| ELEMENTS IDENTIFIED BY REFERENCE NUMERAL | |
|---|---|
| Reference Numeral | Element |
| 10 | optoelectronic assembly |
| 12 | circuit substrate |
| 14 | surface mounted technology components |
| 16 | electrical conductors |
| 18 | photoelectric device |
| 20 | photoactive region |
| 22 | bond pads |
| 24 | adhesive |
| 25 | rectangular regions of adhesive |
| 26 | conductive particles |
| 28 | adhesive matrix |
| 30 | passivation layer |
| 32 | protective encapsulant |
| 34 | optical element |

## Claims

1. An optoelectronic assembly (10) comprising:
(a) a flexible circuit substrate (12) including at least a portion which is substantially transparent to a desired portion of the radiation spectrum; and
(b) a photoelectric device (18) having a photoactive portion on a front surface, said front surface facing said transparent portion of said circuit substrate (12).

2. The optoelectronic assembly (10) as set forth in claim 1, further comprising:
(i) at least one electrical component (14) positioned on said circuit substrate (12); and
(ii) at least one electrical conductor (16) inter-connecting said electrical component (14) with said photoelectric device (18).

3. The optoelectronic assembly (10) as set forth in claim 2, wherein said photoelectric device (18) further comprises at least one bond pad (22) for providing operative connection between said photoelectric device (18) and said electrical conductor (16).

4. The optoelectronic assembly (10) as set forth in claim 3, wherein said bond pad (22) is positioned on said front surface of said photoelectric device (18).

5. The optoelectronic assembly (10) as set forth in claim 1, wherein said photoelectric device (18) is bonded to said circuit substrate utilizing an electrically conductive adhesive.

6. The optoelectronic assembly (10) as set forth in claim 1, wherein said photoelectric device (18) is bonded to said circuit substrate (12) utilizing an adhesive selected from the group consisting of: anisotropic adhesive, isotropic adhesive, and monosotropic adhesive.

7. A method for producing an optoelectronic assembly (10), said method comprising the steps of:
(a) providing a circuit substrate (12) having at least a portion which is substantially transparent to a desired portion of the radiation spectrum, and further including an electrical conductor (16) positioned thereon;
(b) providing a photoelectric device (18) having a photoactive portion on a front surface thereof;
(c) positioning the photoactive portion of the photoelectric device (18) to face the transparent portion of the circuit substrate (12);
(d) securing the photoelectric device (18) to the circuit substrate (12) such that the front surface of the photoelectric device (18) faces toward the circuit substrate (12) to provide operative connection between the photoelectric device (18) and the electrical conductor (16); and
(e) securing an electrical component (14) to the circuit substrate (12) to provide operative connection between the electrical component (14) and the electrical conductor (16).

8. The method, as set forth in claim 7, wherein said photoelectric device (18) includes a bond pad (22) on the front surface thereof, and wherein said method further comprises the step of aligning the bond pad (22) of the photoelectric device (18) with the electrical conductor (16).

9. The method, as set forth in claim 8, wherein said bond pad (22) includes conductive bumps.

10. The method, as set forth in claim 7, wherein said step of securing comprises:
(i) applying a conductive adhesive (24) to at least one of:
a) the circuit substrate (12), to at least partially cover the electrical conductor (16), and
b) the photoelectric device (18), to at least partially cover the bond pad (22); and
(ii) positioning the front surface of the photoelectric device (18) to face toward the circuit substrate (12).
